# EUROPEAN PATENT APPLICATION

(11) **EP 4 745 585 A1**
(43) Date of publication of application: **20.05.2026**
(21) Application number: 25214748.3
(22) Date of filing: 10.11.2025
(51) Int. Cl.: G01R 13/02, G01R 31/28, G01R 31/3181

(54) **TEST AND MEASUREMENT INSTRUMENT WITH BUILT-IN ADVANCED DATA PATTERN GENERATOR**

(30) Priority: 11.11.2024 US 202463719037 P; 03.11.2025 US 202519377865
(71) Applicant: Tektronix, Inc., Beaverton, OR 97077 (US)
(72) Inventor: CHETTY, Dananjeya, Beaverton, 97077-0001 (US); ANDREWS, Jed H., Beaverton, 97077-0001 (US)
(74) Representative: HGF

(57) **Abstract**

A test and measurement instrument includes a display, one or more transmitters, one or more receivers, one or more channels configured to send and receive signals, a data pattern generator, and a high-speed serial trigger (HSST) circuit operating at 1 Gigabits per second or faster connected to the one or more receivers to receive data patterns from the data pattern generator to exercise the high-speed serial trigger circuit.

## Description

### CROSS-REFERENCE TO RELATED APPLICATIONS

This disclosure is a non-provisional of and claims benefit from U.S. Provisional Application No. 63/719,037, titled "TEST AND MEASUREMENT INSTRUMENT WITH BUILT-IN ADVANCED DATA PATTERN GENERATOR," filed on November 11, 2024, the disclosure of which is incorporated herein by reference in its entirety.

### TECHNICAL FIELD

This disclosure relates to test and measurement instruments, and more particularly to a test and measurement instrument, such as an oscilloscope, having a built-in advanced data pattern generator.

### BACKGROUND

Arbitrary waveform generators (AWGs) comprise a type of test and measurement instrument that provides the signals used to test devices under test (DUT). Typically, users employ these in addition to the measurement types of test and measurement instruments.

Some test and measurement instruments, such as oscilloscopes, have integrated or built-in arbitrary function generators (AFGs). AFGs can generate functions, but typically in the analog domain. Currently no options exist to loop back high-speed serial data to the instrument's analog channels.

Being able to use the same instrument for data pattern generation that performs the test and measurement on a DUT would eliminate a lot of complexity in the testing environment.

### BRIEF DESCRIPTION OF THE DRAWINGS

FIG. 1 shows an embodiment of a test and measurement instrument having an advanced data pattern generator.
FIG. 2 shows an embodiment of a user interface that allows a user to select a scrambler and encoder to generate a corresponding waveform.
FIG. 3 shows a flowchart of an embodiment of a method of generating an advanced data pattern waveform.

### DETAILED DESCRIPTION

Embodiments of the disclosure generally include an advanced data pattern generator integrated within a test and measurement instrument for signal analysis, such as an oscilloscope, for example. The advanced data pattern generator output signal can be used either externally to the instrument or internally routed to the front end of a channel for direct acquisition as well. For example, according to some embodiments of the disclosure, an oscilloscope with a built-in advanced high speed serial data pattern generator can loop back the high-speed serial data to the scope's analog channels. This makes it easier for users to exercise the high-speed trigger capabilities, or any other features, of the oscilloscope. Further, according to some embodiments, there will be capability to create or load the waveforms of different protocols based on the scrambling and encoding mechanisms.

Embodiments of the disclosure are not necessarily limited to being implemented in an oscilloscope. The built-in advanced data pattern generator can also exercise features of any piece of test equipment or a device under test (DUT). It does not necessarily have to be an oscilloscope. One embodiment comprises an oscilloscope with an advanced data pattern generator with or without a high-speed serial trigger circuit.

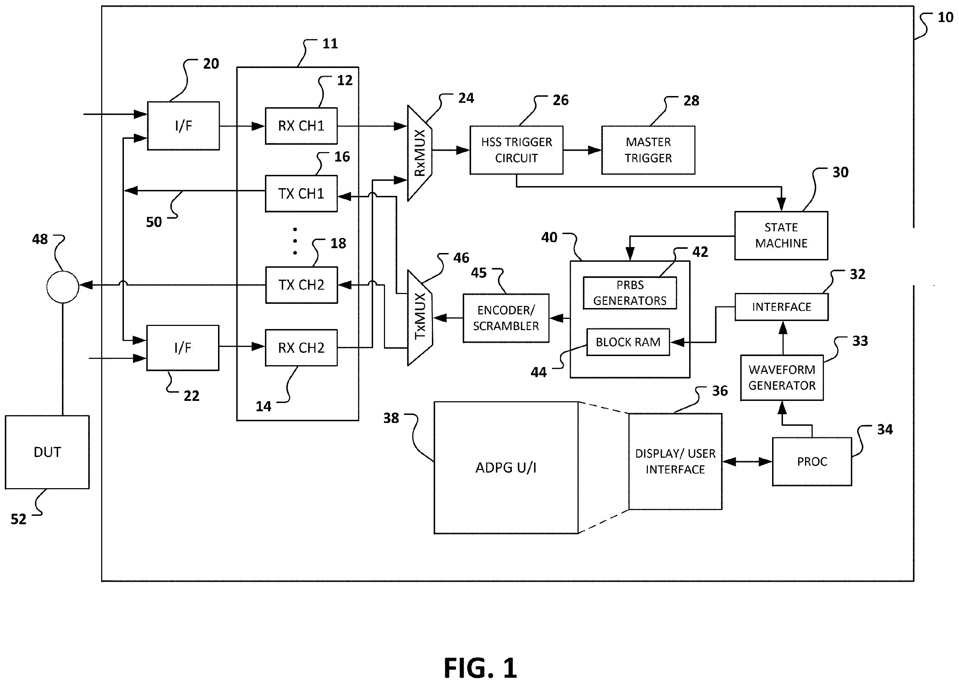

FIG. 1 shows an embodiment of a test and measurement instrument 10 having an advanced data pattern generator. Using the advanced data pattern generator (ADPG) allows for validation of any high-speed serial triggers or other instrument features. The ADPG could be used in the quality control phase of any instrument or other product to validate high-speed serial triggers (HSST). Users will have the ability to generate customizable waveforms, such as inserting error bits, or loading any waveform of interest from memory. The ADPG can generate high-speed waveforms based on the available bandwidth of the instrument, which in some embodiments exceeds 25 Gigabits per second (Gbps). The ADPG allows the user to exercise any instrument, other test equipment or device under test (DUT). The presence of an ADPG inside another instrument such as an oscilloscope eliminates the need for another piece of equipment like an Arbitrary Waveform Generator.

As used herein, the term "high-speed" means a speed of 1 Gigabit per second (Gbps) or higher.

In FIG. 1, instrument 10 has one or more transmitters and one or more receivers, which may comprise one or more transceivers that have both. The discussion below will refer to transmitters and receivers being associated with channels 1 and 2 of the instrument, with the understanding that the instrument may include many more transmitters, receivers, and channels. The use of numbers 1 and 2 is to differentiate between two different channels, not to imply that only two channels exist. In the embodiment shown in FIG. 1, the instrument has a receiver 12 connected to channel 1 of the instrument, and a receiver 14 connected to a second channel, channel 2. The instrument also has one or more transmitters, such as transmitter 16 on channel 1 and transmitter 18 on channel 2. The input channels connected to receivers 12 and 14 may include an interface (I/F) circuit or chip of some type, such as an Application Specific Integrated Circuit (ASIC) to receive the incoming signal, 20 for receiver 12 and 22 for receiver 14. A receiver multiplexer (RxMUX) 24 controls which channel receiving data connects to the high-speed serial trigger (HSST) circuit 26. The transmitters 16 and 18 may have built-in pre-emphasis capabilities for signal losses in the network into which they are driving a signal.

The two receivers 12 and 14 act as a deserializer, converting high-speed serial data to low-speed parallel data. In most instances, the receiver such as 12 and 14 serves as a clock data recovery (CDR) module. As an example, the receiver could comprise an Intel H-tile, but no limitation to any particular high-speed circuit is intended, nor should any be implied. The HSST circuit 26 receives the parallel low speed data from the RxMUX 24 that contains the data from the selected high-speed receiver and is the primary flexible serial trigger logic/state machine typically housed within an instrument to allow the user to trigger the instrument on the desired pattern, error, sequence, etc. The output of the HSST 26 normally triggers the master trigger 28 of the instrument, but also could be a stimulus to the ADPG state machine 30.

On the transmission side, the ADPG receives inputs from an ADPG user interface 38 displayed on display 36. The display 36 may comprise a touchscreen or have adjacent user controls, the combination of which comprises the user interface. The user interacts with instrument 10 through the display/user interface 36 and selects, enters, or otherwise provides a data pattern to be generated. Some of this may involve executable code, software, running on one or more processors such as 34. This information passes to the one or more processors which then create or access, if stored, the pattern to be generated, and sends the pattern to the waveform generator 33. The waveform generator 33 may comprise many components, not shown here. These may include, but are not limited to, oscillators, a waveform generator/shaping circuit, a modulator, and a signal conditioning stage.

The waveform generator 33 then sends the waveform data through an interface 32, such as a Peripheral Component Interface express (PCIe) interface. State machine 30 may respond to different stimulus. State machine 30 may control what pattern is played back, stepping through different patterns in memory, etc. It may receive patterns received through the receivers 12 and 14 and change patterns or otherwise alter the pattern coming through the interface 32.

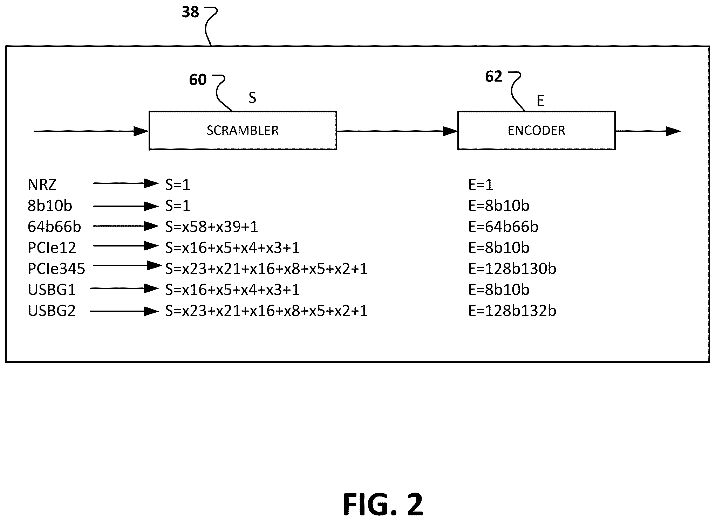

Block 40 contains a PRBS generator (Pseudo-Random Binary Sequence) 42 and a block RAM 44. In one embodiment, a Field Programmable Gate Array (FPGA), may contain the components from the interface 32 to the receivers and transmitters in block 11. This comprises only one example, and other configurations are possible. The output of block 40 goes to the encoder/scrambler 45, which is described in more detail below with regard to the user interface in FIG. 2.

The transmitter multiplexer (TxMUX) 46 does not really function as a multiplexer in one embodiment. Rather than selecting the channel that receives the output, the TxMUX sends the same output signal to both the internal channel and the external connector interface. In another embodiment, the TxMUX 46 could select which channel receives the generated data pattern. In one embodiment, the transmitter connected to channel 2 outputs the signal external to the instrument 10, through external connector interface 48. The interface 48 is external in that it passes the data pattern external to the instrument 10, not that the interface 48 is external to the instrument. It may be part of instrument 10. The provision of the data pattern external to the instrument may enable many different uses, including applying the data pattern to a device under test 52. The external connector interface 48 may comprise one of many different types of interfaces, such as RF (radio frequency) interfaces including a SubMiniature Type A (SMA) interface.

In another embodiment, the TxMUX 46 may select to output the data pattern through path 50, which may then be re-routed internally to one or more of the instrument channel input I/Fs 20 and 22, to go to the receivers 12 and 14 without the use of a cable external to the instrument 10. The ability to route the output data pattern to the incoming instrument channels allows the exercising, testing and demonstration of the high-speed serial data trigger capabilities of the instrument discussed above.

To enable the users to select the desired pattern to be generated, the ADPG U/I 38 may provide the user with a list of possible scramblers and encoders, shown in more detail in FIG. 2. For high-speed protocols, the user generally needs to consider two blocks, the scrambler 60 and the encoder 62, when generating a known waveform for the HSST data path to set up any trigger of interest. FIG. 2 shows different protocols, such as NRZ, 8b10b, etc., and the associated scrambler and encoder schemes. The PCIe12 shown in the interface means PCIe Generations 1 and 2, and PCIe345 refers to PCIe Gens 3, 4 and 5. USBG1 and USBG2, refer to USB3 Gens 1 and 2.

Users can select options from each S and E drop-down menu 60, 62 based on the type of waveform of interest, as shown in FIG. 2. For better visibility, the user interface may include the polynomials and types of encoding required for each protocol to generate waveforms. These selections just demonstrate some of the options. The selections may also include PAM (Pulse Amplitude Modulation) to support PCIe 6 and USB (universal serial bus) version 4.

The user configures the system through U/I 38. The customer provides a high- or low-level description through the U/I 38 and the waveform generator 33 takes those inputs and generates the waveform. The waveform generator 33 may alter the inputs as needed to generate the waveform and then sends the waveform to the block RAM 44. The waveform may be generated by the waveform generator 33 in FIG. 1 or could be "generated" by accessing a pre-defined waveform in the memory represented by the block RAM 44. One example of low-level control may involve the user manually typing in the bit pattern, including any error bits, or other anomalies the user wants to include. When the user inputs a pattern of 0s and 1s, the state machine 30 uses this section of memory in block RAM 44 to send out the user's pattern without alteration, bypassing the encoder/scrambler 45.

High-level control may involve the user just selecting a PCIe compliance pattern, or one with a similar general label, on a repeating loop. The waveform generator 33 knows what the compliance pattern is, so it may take the raw compliance pattern and pass it to the encoder/scrambler 45 to generate the data to store in the block RAM 44. Since the data is already encoded/scrambled, the state machine again sends out the raw data stored in the block RAM 44.

In another example of high-level control, the user may want an infinite series of scrambled PCIe packets as an example. The pattern length is too long to precompute and put into block RAM 44. The waveform generator 33 just loads 0s into the block RAM 44 and enables the encoder/scrambler 45 to continuously scramble the 0s payload and transmit it indefinitely.

The data pattern being generated as the waveform is alterable. Conditions that may alter the data pattern include, but are not limited to, a second user input after the user input that selects or inputs the data pattern, a trigger occurring at the HSST circuit, a particular state of the instrument, such as after each acquisition if the instrument is an oscilloscope. Other alterations may occur.

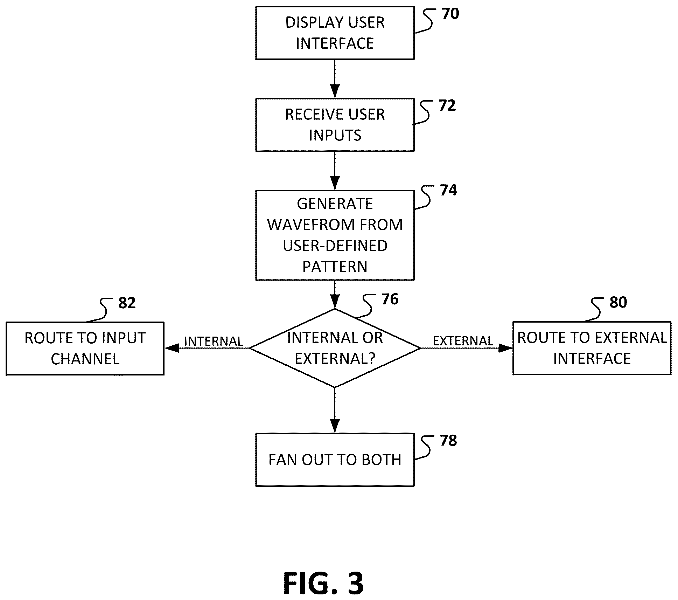

FIG. 3 shows a flowchart of a process of generating a waveform from a user input. The process begins at 70 with the instrument displaying the ADPG user interface. The user makes their selection, received by the instrument at 72. At 74, the instrument generates the waveform corresponding to the user-defined pattern. The generation of the pattern may use the scrambler, the encoder, both, or neither. In the case of one or both of the scrambler and encoding not being used, the data will just pass through encoder/scrambler 45. Referring back to FIG. 1, the instrument will load the waveform into the memory represented by the block RAM 44, to be read out once the transmission path is selected. As mentioned above, generating the waveform also includes accessing previous waveforms from memory. In one embodiment, at 76, the process may determine that the instrument sends the signal to both the internal and external pathways, if so, it is done at 78 as discussed above. In an alternative embodiment, the instrument could select either the internal path at 82 or the external interface at 80.

In one embodiment, where the receiver 12 or 14 functions as a deserializer, that function uses one receiver. Where the transmitter and receiver are part of the same transceiver, the transmitter channel associated with the used receiver remains unused. The ability to employ that unused transmitter channel for internal routing of a high-speed signal does not increase the hardware requirements of the instrument.

The above discussion demonstrates that one can provide an advanced data pattern generator (ADPG) to an existing instrument, removing the need for extra equipment as would be the case if an Arbitrary Waveform Generator were used.

The external path through which the signal would be routed to the external interface would allow user to pass the transmitted test signal through any channel they could devise, such as long coax, PCB loss traces, crosstalk injection, etc, to degrade the signal and then run it back into the input channel and further exercise the capabilities of the HSST. Most of the limits on how much analog degradation of the test signal the receiver can tolerate would be set by the receiver itself. The receiver plus HSST logic enables triggering the instrument on an applied signal, either from customer or signal from ADPG, in a non-ideal domain meaning a degraded signal. The ADPG may not play much of a role in this embodiment because users are usually interested in their signals. The ADPG adds a stimulus that would otherwise require another instrument to generate a signal that could be used to drive the user's DUT which performs some function on that data. Its output could be acquired and analyzed on the scope and HSST combination.

Aspects of the disclosure may operate on a particularly created hardware, on firmware, digital signal processors, or on a specially programmed general purpose computer including a processor operating according to programmed instructions. The terms controller or processor as used herein are intended to include microprocessors, microcomputers, Application Specific Integrated Circuits (ASICs), and dedicated hardware controllers. One or more aspects of the disclosure may be embodied in computer-usable data and computer-executable instructions, such as in one or more program modules, executed by one or more computers (including monitoring modules), or other devices. Generally, program modules include routines, programs, objects, components, data structures, etc. that perform particular tasks or implement particular abstract data types when executed by a processor in a computer or other device. The computer executable instructions may be stored on a non-transitory computer readable medium such as a hard disk, optical disk, removable storage media, solid state memory, Random Access Memory (RAM), etc. As will be appreciated by one of skill in the art, the functionality of the program modules may be combined or distributed as desired in various aspects. In addition, the functionality may be embodied in whole or in part in firmware or hardware equivalents such as integrated circuits, FPGA, and the like. Particular data structures may be used to more effectively implement one or more aspects of the disclosure, and such data structures are contemplated within the scope of computer executable instructions and computer-usable data described herein.

The disclosed aspects may be implemented, in some cases, in hardware, firmware, software, or any combination thereof. The disclosed aspects may also be implemented as instructions carried by or stored on one or more or non-transitory computer-readable media, which may be read and executed by one or more processors. Such instructions may be referred to as a computer program product. Computer-readable media, as discussed herein, means any media that can be accessed by a computing device. By way of example, and not limitation, computer-readable media may comprise computer storage media and communication media.

Computer storage media means any medium that can be used to store computer-readable information. By way of example, and not limitation, computer storage media may include RAM, ROM, Electrically Erasable Programmable Read-Only Memory (EEPROM), flash memory or other memory technology, Compact Disc Read Only Memory (CD-ROM), Digital Video Disc (DVD), or other optical disk storage, magnetic cassettes, magnetic tape, magnetic disk storage or other magnetic storage devices, and any other volatile or nonvolatile, removable or non-removable media implemented in any technology. Computer storage media excludes signals per se and transitory forms of signal transmission.

Communication media means any media that can be used for the communication of computer-readable information. By way of example, and not limitation, communication media may include coaxial cables, fiber-optic cables, air, or any other media suitable for the communication of electrical, optical, Radio Frequency (RF), infrared, acoustic or other types of signals.

### EXAMPLES

Illustrative examples of the disclosed technologies are provided below. An embodiment of the technologies may include one or more, and any combination of, the examples described below.

Example 1 is a test and measurement instrument, comprising: a display; one or more transmitters; one or more receivers; one or more channels configured to send and receive signals; a data pattern generator; and a high-speed serial trigger (HSST) circuit operating at 1 Gigabits per second or faster connected to the one or more receivers to receive one or more data patterns from the data pattern generator to exercise the high-speed serial trigger circuit.

Example 2 is the test and measurement instrument of Example 1, or any other Example herein, wherein an output of one of the one or more transmitters is connected to an input channel of the test and measurement instrument.

Example 3 is the test and measurement instrument of either of Examples 1 or 2, or any other Example herein, wherein an output of one of the one or more transmitters is connected to an external connector interface of the test and measurement instrument.

Example 4 is the test and measurement instrument of any of Examples 1 through 3, or any other Example herein, further comprising one or more processors, the data pattern generator comprising code executed by the one or more processors to cause the one or more processors to generate the data patterns.

Example 5 is the test and measurement instrument of Example 4, or any other Example herein, wherein the one or more processors are further configured to execute code to cause the one or more processors to display a user interface on the display.

Example 6 is the test and measurement instrument of Example 5, or any other Example herein, wherein the code that causes the one or more processors to display the user interface comprises code to cause the one or more processors to receive a user input to designate a pattern to be generated.

Example 7 is the test and measurement instrument of Example 6, or any other Example herein, wherein the user input may comprise one of a training pattern, a stored pattern, a manually-entered pattern, or an altered pattern.

Example 8 is the test and measurement instrument of Example 6, or any other Example herein, wherein the data pattern generated is alterable by one or more of a user input through the user interface, a trigger event from the HSST circuit, and a change to a state of the test and measurement instrument.

Example 9 is the test and measurement instrument of any of Examples 1 through 8, or any other Example herein, further comprising a scrambler and an encoder.

Example 10 is the test and measurement instrument of Example 9, or any other Example herein, wherein the data pattern generated results from the scrambler, the encoder, or both the scrambler and the encoder.

Example 11 is a method of generating data patterns from a test and measurement instrument, comprising: displaying a user interface providing selections to allow a user to define a data pattern; receiving, through the user interface, a user-defined data pattern; generating a waveform from the user-defined data pattern; and selectively routing the waveform to at least one of an input channel of the test and measurement instrument and an external interface of the test and measurement instrument.

Example 12 is the method of Example 11, or any other Example herein, wherein generating the waveform comprises generating a new waveform from the user-defined data pattern.

Example 13 is the method of either of Examples 11 or 12, or any other Example herein, wherein generating the waveform comprises accessing a memory to retrieve data corresponding to the user-defined data pattern.

Example 14 is the method of any of Examples 11 through 13, or any other Example herein, further comprising receiving, through the user interface, a selection of a routing of the waveform.

Example 15 is the method of any of Examples 11 through 14, or any other Example herein, wherein generating the waveform comprises generating the waveform at 1 Gigabit per second or faster.

Example 16 is the method of any of Examples 11 through 15, or any other Example herein, wherein generating the waveform comprises altering the waveform from one or more of a second user input received through the user interface.

Example 17 is the method of any of Examples 11 through 16, or any other Example herein, wherein generating the waveform comprises one of using a scrambler, using an encoder, using both the scrambler and the encoder, or not using either the scrambler or encoder.

Example 18 is an oscilloscope, comprising: a display; one or more transmitters; one or more receivers; one or more channels configured to send and receive signals; a data pattern generator to generate a waveform from a user-defined data pattern; and a path selector to selectively route the waveform to at least one of either an input channel of the oscilloscope and an external connector interface of the oscilloscope.

Example 19 is the oscilloscope of Example 18, or any other Example herein, wherein the data pattern generator operates at 1 Gigabit per second or faster.

Example 20 is the oscilloscope of either of Examples 18 or 19, or any other Example herein, further comprising one or more processors, the data pattern generator comprising code executed by the one or more processors to cause the one or more processors to generate data patterns.

Example 21 is the oscilloscope of Example 20, or any other Example herein, wherein the one or more processors are further configured to execute code to cause the one or more processors to display a user interface on the display.

Example 22 is the oscilloscope of Example 21, or any other Example herein, wherein the code that causes the one or more processors to display the user interface comprises code to cause the one or more processors to receive a user input to designate a data pattern to be generated.

Example 23 is the oscilloscope of Example 22, or any other Example herein, wherein the user input may comprise one of a training pattern, a stored pattern, a manually-entered pattern, or an altered pattern.

Example 24 is the oscilloscope of Example 22, or any other Example herein, wherein the data pattern generated is alterable by one or more of a user input through the user interface and a change to a state of the oscilloscope.

Example 25 is the oscilloscope of Example 18, or any other Example herein, further comprising a scrambler and an encoder.

Example 26 is the oscilloscope of Example 25, or any other Example herein, wherein the data pattern generated results from the scrambler, the encoder, or both the scrambler and the encoder.

All features disclosed in the specification, including the claims, abstract, and drawings, and all the steps in any method or process disclosed, may be combined in any combination, except combinations where at least some of such features and/or steps are mutually exclusive. Each feature disclosed in the specification, including the claims, abstract, and drawings, can be replaced by alternative features serving the same, equivalent, or similar purpose, unless expressly stated otherwise.

Additionally, this written description makes reference to particular features. It is to be understood that the disclosure in this specification includes all possible combinations of those particular features. For example, where a particular feature is disclosed in the context of a particular aspect, that feature can also be used, to the extent possible, in the context of other aspects.

Also, when reference is made in this application to a method having two or more defined steps or operations, the defined steps or operations can be carried out in any order or simultaneously, unless the context excludes those possibilities.

Although specific aspects of this disclosure have been illustrated and described for purposes of illustration, it will be understood that various modifications may be made without departing from the scope of the invention. Accordingly, the invention should not be limited except as by the appended claims.

## Claims

1. A test and measurement instrument, comprising:
a display;
one or more transmitters;
one or more receivers;
one or more channels configured to send and receive signals;
a data pattern generator; and
a high-speed serial trigger (HSST) circuit operating at 1 Gigabits per second or faster connected to the one or more receivers to receive data patterns from the data pattern generator to exercise the high-speed serial trigger circuit.

2. The test and measurement instrument as claimed in claim 1, wherein an output of one of the one or more transmitters is connected to an input channel of the test and measurement instrument; and/or
wherein an output of one of the one or more transmitters is connected to an external connector interface of the test and measurement instrument.

3. The test and measurement instrument as claimed in claim 1 or 2, further comprising one or more processors, the data pattern generator comprising code executed by the one or more processors to cause the one or more processors to generate the data patterns.

4. The test and measurement instrument as claimed in claim 3, wherein the one or more processors are further configured to execute code to cause the one or more processors to display a user interface on the display, optionally wherein the code that causes the one or more processors to display the user interface comprises code to cause the one or more processors to receive a user input to designate a pattern to be generated.

5. The test and measurement instrument as claimed in claim 4, wherein the user input may comprise one of a training pattern, a stored pattern, a manually-entered pattern, or an altered pattern; and/or wherein the data pattern generated is alterable by one or more of a user input through the user interface, a trigger event from the HSST circuit, and a change to a state of the test and measurement instrument.

6. The test and measurement instrument as claimed in any of claims 1 to 5, further comprising a scrambler and an encoder; and/or
wherein the generated data pattern comes from the scrambler, the encoder, or both the scrambler and the encoder.

7. A method of generating data patterns from a test and measurement instrument, comprising:
displaying a user interface providing selections to allow a user to define a data pattern;
receiving, through the user interface, a user-defined data pattern;
generating a waveform from the user-defined data pattern; and
selectively routing the waveform to at least one of an input channel of the test and measurement instrument and an external interface of the test and measurement instrument.

8. The method as claimed in claim 7, wherein generating the waveform comprises generating a new waveform from the user-defined data pattern; and/or
wherein generating the waveform comprises accessing a memory to retrieve data corresponding to the user-defined data pattern; and/or
further comprising receiving, through the user interface, a selection of a routing of the waveform; and/or
wherein generating the waveform comprises generating the waveform at 1 Gigabit per second or faster; and/or
wherein generating the waveform comprises altering the waveform from one or more of a second user input received through the user interface; and/or
wherein generating the waveform comprises one of using a scrambler, using an encoder, using both the scrambler and the encoder, or not using either the scrambler or encoder.

9. An oscilloscope, comprising:
a display;
one or more transmitters;
one or more receivers;
one or more channels configured to send and receive signals;
a data pattern generator to generate a waveform from a user-defined data pattern; and
a path selector to selectively route the waveform to at least one of either an input channel of the oscilloscope and an external connector interface of the oscilloscope.

10. The oscilloscope as claimed in claim 9, wherein the data pattern generator operates at 1 Gigabit per second or faster; and/or further comprising one or more processors, the data pattern generator comprising code executed by the one or more processors to cause the one or more processors to generate data patterns.

11. The oscilloscope as claimed in claim 10, wherein the one or more processors are further configured to execute code to cause the one or more processors to display a user interface on the display, optionally wherein the code that causes the one or more processors to display the user interface comprises code to cause the one or more processors to receive a user input to designate a data pattern to be generated, optionally wherein the user input may comprise one of a training pattern, a stored pattern, a manually-entered pattern, or an altered pattern.

12. The oscilloscope as claimed in claim 10 or 11, wherein the generated data pattern is alterable by one or more of a user input through the user interface and a change to a state of the oscilloscope.

13. The oscilloscope as claimed in any of claims 9 to 12, further comprising a scrambler and an encoder.

14. The oscilloscope as claimed in claim 13, wherein the generated data pattern is from the scrambler, the encoder, or both the scrambler and the encoder.
